# EUROPEAN PATENT SPECIFICATION

(11) **EP 2 196 564 B1**
(45) Date of publication and mention of the grant of the patent: **06.03.2013**
(21) Application number: 08834751.3
(22) Date of filing: 03.10.2008
(51) Int. Cl.: C30B 29/04, C23C 16/27, H01L 21/205

(54) **ISOTOPE DIAMOND LAMINATE**
ISOTOPENDIAMANTLAMINAT
STRATIFIÉ DE DIAMANT ISOTOPIQUE

(30) Priority: 03.10.2007 JP 2007259942
(43) Date of publication of application: 16.06.2010
(73) Proprietor: National Institute of Advanced Industrial Science and Technology, Tokyo 100-8921 (JP)
(72) Inventor: WATANABE, Hideyuki, Tsukuba-shi Ibaraki 305-8568 (JP); NEBEL, Christoph, Tsukuba-shi Ibaraki 305-8568 (JP); SHIKATA, Shinichi, Tsukuba-shi Ibaraki 305-8568 (JP)
(74) Representative: HOFFMANN EITLE
(86) International application number: PCT/JP2008/068091
(87) International publication number: WO 2009/044882

(56) References cited:
- EP-A1- 1 414 079
- WO-A1-00/63956
- JP-A- 4 270 193
- JP-A- 5 270 987
- JP-A- 11 297 624
- JP-A- 2003 051 609
- US-B1- 6 653 212
- HALLER E E: "ISOTOPICALLY CONTROLLED SEMICONDUCTORS", JOURNAL OF NUCLEAR SCIENCE AND TECHNOLOGY, ATOMIC ENERGY SOCIETY OF JAPAN, JP, vol. 39, no. 4, 1 April 2002 (2002-04-01), pages 382-385, XP008042044, ISSN: 0022-3131
- KOJIMA T ET AL: "Growth and characterization of 28Sin/30Sin isotope superlattices", APPLIED PHYSICS LETTERS, AIP, AMERICAN INSTITUTE OF PHYSICS, MELVILLE, NY, US, vol. 83, no. 12, 22 September 2003 (2003-09-22), pages 2318-2320, XP012035138, ISSN: 0003-6951, DOI: DOI:10.1063/1.1613365
- C. PARKS, A.K. RAMDAS, S. RODRIGUEZ, K.M. ITOH AND E.E. HALLER: "Electronic band structure of isotpically pure germanium: Modulated transmission and reflectivity study", PHYSICLA REVIEW B, vol. 49, 14244, 15 May 1994 (1994-05-15), pages 14244-14250, XP002629716,
- PLEKHANOV V G: "Isotope effects on the lattice dynamics of crystals", MATERIALS SCIENCE AND ENGINEERING R: REPORTS, ELSEVIER SEQUOIA S.A., LAUSANNE, CH, vol. 35, no. 4-6, 28 December 2001 (2001-12-28), pages 139-237, XP004313103, ISSN: 0927-796X, DOI: DOI:10.1016/S0927-796X(01)00038-9
- BEREZIN ET AL: "Localized states associated with isotopic islands", JOURNAL OF PHYSICS AND CHEMISTRY OF SOLIDS, PERGAMON PRESS, LONDON, GB, vol. 48, no. 9, 1 January 1987 (1987-01-01), pages 853-855, XP024540096, ISSN: 0022-3697, DOI: DOI:10.1016/0022-3697(87)90038-2 [retrieved on 1987-01-01]
- BEREZIN ET AL: "Isotopic superlattices and isotopically ordered structures", SOLID STATE COMMUNICATIONS, PERGAMON, GB, vol. 65, no. 8, 1 February 1988 (1988-02-01), pages 819-821, XP024590942, ISSN: 0038-1098, DOI: DOI:10.1016/0038-1098(88)90512-1 [retrieved on 1988-02-01]

## Description

### TECHNICAL FIELD

The present invention relates to a stacked body of isotope diamond and a method of producing the same.

### BACKGROUND ART

Development of crystal growth technology has realized new semiconductor devices based on new physical concepts. One of the remarkable crystal designing technology is related to a semiconductor super-lattices constituted of different semiconductor materials alternately stacked in planer (one dimensional), linier (two dimensional), or blocked (three dimensional) arrangement. An important concept of this technology is in that electric structure of a crystal can be modulated by stacking two layers of semiconductor materials having different band-gap, or by forming a periodic structure in which the two-layered structure as a unit structure is repeated. Recently, attention has been paid to using a super lattice having a periodic structure of artificially developed potential as a confining technology for overcoming limits on the properties of semiconductor materials. Practically, the super-lattice is a crystal formed by artificially stacking different semiconductor materials each having a layer thickness of mono-atomic thickness to several 10s nm (typically, about 50 nm) to provide a long-range periodical structure. Numerous physical phenomena which are not shown by a bulk single crystal are observed in the super-lattice, providing various fundamental problems not only in the field of physics, but also in the field of application.

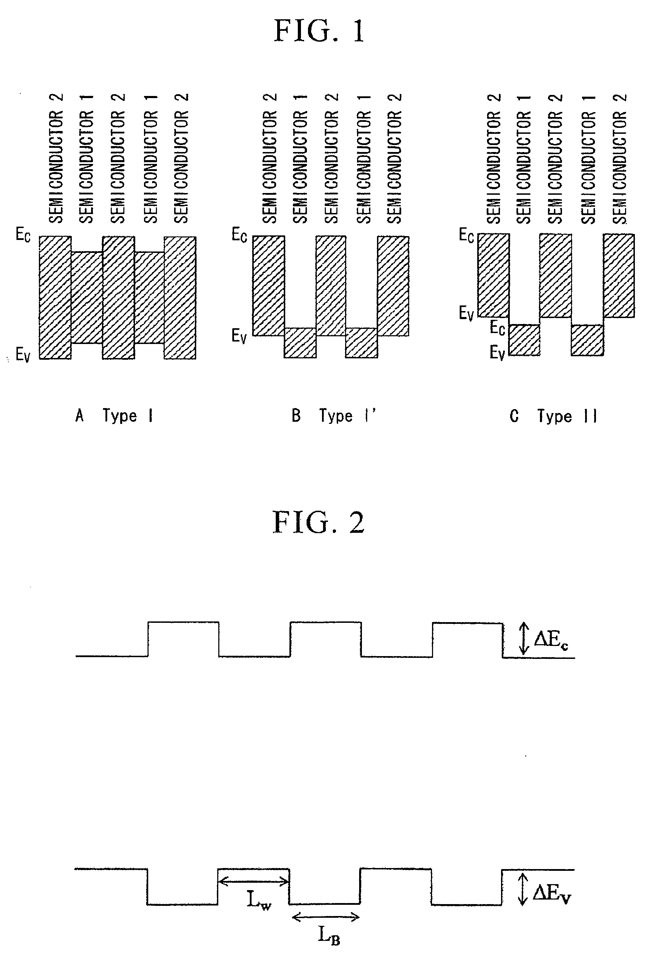

In many cases, crystals of one dimensional super-lattice structure (hereafter, referred to as a super lattice structure or a super lattice) are classified to type I, type I', and type II in accordance with their characteristics of energy band-gap structures. Therefore, the following explanation is based on this classification.
Each of FIGS. 1(a) to (c) shows a super-lattice of type I, type I', and type II respectively. In each figure, Ec and Ev respectively denote conduction band and valence band.
In type I and type I', conduction band and valence band of each of two semiconductors 1 and 2 overlap each other, and the band-gap changes discontinuously. As a representative stacked (layered) structure of type I super lattice, there exists a structure in which GaAs is used in semiconductor 1 and AlₓGa₁₋ₓAs is used in semiconductor 2. As a representative stacked structure of type I' super lattice, there exists a structure in which In₁₋ₓGaₓAs and GaSb_{1-y}As_{y} are used in semiconductor 1 and semiconductor 2 respectively. On the other hand, in a type II super lattice, valence band of a semiconductor overlaps the conduction band of the other semiconductor. As a representative stacked structure of this type super lattice, there exists a structure in which InAs is used as the semiconductor 1 and GaSb is used as the semiconductor 2.

As an alternative to the above described ΔEc and ΔEv that denote discontinuities of energy bands in conduction band and valence band, electronic state of a super lattice may be characterized by another parameters. For example, electronic state of type I super-lattice may be approximately expressed by a square-well potential as shown in FIG. 2. In this case, the electronic state depends on four parameters shown by with Lw of the well and with L_{B} of the barriers.
For example, where L_{W} and L_{B} are each controlled to be a similar level as de Bloglie wavelength of an electron (for example, in GaAs-AlₓGa₁₋ₓAs, L_{W} may be controlled to be 30 nm or less, and L_{B} may be controlled to be 10 nm or less), periodic potential longer than usual lattice spacing is introduced into a crystal, and a mini-band is formed. As a result, the role of the quantum effect is shown remarkably. For example, electrons can transmit (propagate) in a material with high mobility. Such electrons are actually used in some devices. A representative device is a High Electron Mobility Transistor (HEMT). In this device, secondary electron gas having extremely high mobility is formed in the layers of semiconductor 1 by a modulation doping super lattice structure in which doping (for example introduction of n-type dopant) is performed only in the layers of semiconductor 2 of a type I super lattice. In general, an active layer for transmitting electron current includes impurities for ensuring a conduction, but the impurities act as the the dominant scattering factor that suppresses the mobility of electrons. However, since an electron fallen in the well of the semiconductor 1 is spatially separated from the impurities, the electrons hardly suffer scattering by the impurities, and mobility is largely improved, enabling actual use. Especially, in accordance with recent remarkable spreading of mobile information instruments and increasing data volume and signaling speed for wireless communication by the instruments, there is a demand for HEMT that enables high electric power conversion and high frequency operation. Currently, a HEMT utilizing a wide band-gap semiconductor is paid attention to as a device by which high-temperature, high-current, and high withstand voltage operation, and GaN-AlGaN based HEMT is proposed as an alternative to the conventional GaAs-AlGaAs based HEMT.

On the other hand, where L_{B} is controlled to be sufficiently larger than L_{w}, it is possible to form a single-well state that confine carriers in a desired semiconductor layer. This is due to a carrier trapping effect utilizing an energy barrier caused by the difference in band-gaps, and is one of the main characteristics of a super-lattice. A quantum-well laser is a representative example. For example, in the quantum-well laser, shortening of wavelength of laser oscillation, improvement of thermal variation of threshold current density, and enhancement of luminous efficiency are realized along with reduction of L_{w} (for example, GaAs layer is reduced from 20 nm in type I GaAs-AlₓGa₁₋ₓAs).

However, since different species of semiconductors having different lattice constants are joined in the above-described hetero-structured super-lattice, it is impossible to avoid the introduction of defects and strains caused by mismatching the lattice constants. Recently, a super-lattice composed of the same element utilizing isotopes of Si is proposed as an alternative (see Patent References 1 to 3, Non-Patent Reference 1).
Patent Reference 4 relates to diamond high brightness ultraviolet ray emitting elements. The embodiment of the element as shown in Fig. 2 of the reference comprises a ¹²C i-type diamond substrate, a ¹³C n-type diamond layer formed on the ¹²C i-type diamond substrate, a ¹²C i-type diamond layer formed on the ¹³C n-type diamond layer, and a ¹³C p-type diamond layer formed on the ¹²C i-type diamond layer.
Patent Reference 5 is concerned with a thin film forming apparatus, and a method for forming a thin film on a substrate. The method comprises a cleaning step of feeding a carrier gas containing hydrogen to the vacuum chamber and cleaning the top of the substrate by activated hydrogen generated in the fed carrier gas, and a step of forming the thin film on the substrate by feeding a material gas to the vacuum chamber. According to a preferred embodiment, thin films can be stacked on the substrate by repeating the thin film forming step after the cleaning step. The semiconductor thin film can be amongst many others a diamond film.
Patent Reference 1: Japanese Unexamined Patent Application, First Publication No. 2000-26974.
Patent Reference 2: Published Japanese Translation No. H11-500580 of the PCT International Publication.
Patent Reference 3: Japanese Unexamined Patent Application, First Publication, No. H11-297624
Patent Reference 4: EP 1 414 079 A1.
Patent Reference 5: US 6,653,212 B1.
Non Patent Reference 1: Applied Physics Letters 83, 2318 (2003) "Growth and characterization of 28Sin/38Sin isotope superlattices".

### DISCLOSURE OF INVENTION

### Problems to be solved by the invention

Currently, thin film crystallization technology, for example, by Molecular Beam Epitaxy (MBE) or Organometallic Vapor Phase Epitaxy (OMVPE) using organic metals is used in realization of a super lattice structure. In this technology, it is possible to lower the growth rate, and control the film thickness effectively. Further, this technology has an advantage of forming a steep composition profile and impurity profile, since starting and stopping of crystal growth may be controlled by a shutter. Another advantage is an capability of growing various materials. However, semiconductors constituting the super-lattice is practically made of monoatomic layer or a layer of up to several tens of nm in thickness. Therefore, epitaxial growth of high precision in the atomic order is practically required so as to realize precise periodic structure constituted of many tenth layers of those semiconductors. That is, there is increasing demand for suppressing disorder caused by fluctuation and/or strain of layer interface, crystal defects, and heterogeneity in structure so as to achieve optimum device performance by the quantum effect and trapping effect of the super lattice. Further, since the super-lattice realized by chemical compounds such as GaAs has a hetero-structure, it is impossible to avoid an introduction of defects and strains caused by mismatching of lattice constants along with introduction of crystal defects caused by non-stoichiometric composition.

Super-lattice structures utilizing isotopes of single elements, for example, ²⁸(Si)n³⁰(Si)n or ⁷⁰(Ge)n⁷⁴(Ge)n, are proposed for solving the above-described problems. However, at preset, carrier confinement effect utilizing an energy barrier caused by difference in band-gaps has not been observed because of small relative difference between the band-gaps achieved by the isotope effect, for example, 0.36 meV in Ge and 1 meV in Si. That is, it is difficult to obtain the super-lattice effect to sufficiently take an advantage of the barrier effect simultaneously.

Currently, the super-lattice structure is mainly realized of semiconductor materials such as GaAs, InSb, Si, and GaN. To overcome the limit of physical properties specific to the material, replacement of the material is required. For example, in Si and GaAs which are semiconductor materials used in core technologies of current electronic and optoelectronic field, upper limit of operation temperature of a device is limited to about 200°C because of constraint by the band-gap. Therefore, recent enhancement of integration and operation speed of devices reaches the limit because of thermal constraint on the physical properties. Although an application of wide-gap semiconductor of GaN may be expected, the temperature increase of the operation channel by calorification still remains a main problem.

Based on the consideration of the above-described problems, an object of the present invention is to obtain a high performance device which is not restricted by conventional concept of a super lattice and overcomes or loosen limitations on physical properties of materials and problems concerning hetero-junction. Specifically, an object of the present invention is to provide a device in which a desired barrier height, a barrier width, a barrier interval, the numbers of repetitions of stacked layers, or crystal shape are freely controlled such that the device has a desired performance.

### Solution of the problems

As a result of extensive study to achieve the above-described object, the inventors reached the following findings. A fundamental constitution of a high performance device that overcomes or loosen imitation on physical properties of materials and problems concerning hetero-junction can be provided by constituting the main carrier generation region, or a carrier passage and an operation/non-operation channel of an isotope diamond (hereafter, referred to as ¹²C diamond) synthesized from carbon isotope ¹²C and the isotope diamond (hereafter, referred to as ¹³C diamond) synthesized from carbon isotope ¹³C, providing a junction-interface utilizing an energy barrier (quantum barrier) caused by difference in band-gaps formed by quantum effects of the ¹²C diamond and the ¹³C diamond.
While the term "super-lattice" is used in the description of the back ground art, the super-lattice denotes a crystal lattice that is formed by stacking of plural species of crystal lattices and has a periodic structure different from that of basic unit lattices. On the other hand, the effect achieved by the present invention appears even though the basic unit lattice structure in nanometer scale is not changed. Therefore, the structure including the present invention is hereafter referred to as a stacked structure.

The present invention was completed based on the above-described findings and provides the following aspects.
A stacked (layered, laminated) body of isotope diamonds, including a ¹³C film composed of carbon isotope ¹³C and a ¹²C film composed of carbon isotope ¹²C grown on a substrate by epitaxial growth, wherein the stacked body at least has a structure in which the ¹²C film is grown on the ¹³C film. The stacked body is characterized in that the ¹²C film and ¹³C film are alternately stacked plural times, and the thickness of the ¹²C film and the thickness of the ¹³C film are the same.
Preferred embodiments of the stacked body of isotope diamonds are subject of the appending dependent Claims 2 to 4.
According to another aspect, the present invention provides a method of producing a stacked body of isotope diamonds according to the above aspect, including epitaxially growing a ¹³C film composed of carbon isotope ¹³C and a ¹²C film composed of carbon isotope ¹²C on a substrate by CVD method using isotope-refined raw material gases, including performing removal of a residual gas containing unnecessary carbon from an interior of a reaction chamber by a flow of highly purified hydrogen gas and heating of the substrate, wherein the removal of the residual gas is performed before forming the films, and in the time of changing the isotope-refined raw material gas.
The highly purified hydrogen gas has a purity level of 9N.

### Effect of the invention

According to the present invention, it is possible to achieve considerable degree of freedom in forming a desired barrier height, a desired barrier interval, desired numbers of repetitions of stacking(layering), or a desired crystal shape. Therefore, by a replacing the conventional material by isotope diamond while maintaining the conventional device structure, it is possible to provide a photo-luminescent device having high photo-luminescence efficiency and a photo-detecting (light-receiving) device having high light-detection efficiency, where a device performance is improved one or two or more orders compared to the conventional device. Further, the present invention can be applied variously. For example, it is possible to realize ultra-high speed and a low noise high-frequency device, an ultra-high current density power device or the like by applying the present invention to a channel region of a electric field effect transistor (e.g., HEMT, JFET, MESFET or the like) or a drift layer of a power device. Specifically, there is an advantage in that a thermal design (heat design) of a device can be eased automatically by excellent heat conduction of diamonds.

### BRIEF EXPLANATION OF DRAWINGS

FIG. 1 shows types of a super-lattice.
FIG. 2 shows a schematic drawing of a square-well potential.
FIG. 3 shows a change of peak position of exciton luminescence in accordance with a change of ¹³CH₄ gas concentration (x) during the growing of a diamond.
FIG. 4 is a schematic drawing of stacked structures.
FIG. 5 shows schematic drawings of stacked structures composed of ¹²C diamond films and ¹³C diamond films produced in Examples 1 to 3.
FIG. 6 shows an evaluation of the composition of isotope diamonds obtained in Example 1.
FIG. 7 shows an evaluation of electronic states of isotope diamonds obtained in Example 1.
FIG. 8 is a schematic drawing of carrier accumulation.
FIG. 9 shows a change of cathode-luminescence intensity from stacked bodies of isotope diamonds obtained in Examples 1 and 2.
FIG. 10 shows a change of cathode luminescence and luminescence intensity from a prime unit stacked structure of isotope diamonds obtained in Example 3.

### Explanation of symbols

1: ¹³C diamond film
2: ¹²C diamond film
3: high-pressure high-temperature synthesized diamond
4: Flow of carriers
5: Electron
6: Hole
7: Exciton
8: Process of recombination-luminescence from a ¹²C diamond film.

### BEST MODE FOR CARRYING OUT THE INVENTION

Next, the present invention is explained in detail.
An isotope diamond stacked body according to the present invention is a stacked body of isotope diamonds, including a ¹³C film composed of carbon isotope ¹³C and a ¹²C film composed of carbon isotope ¹²C grown on a substrate by epitaxial growth, wherein the stacked body at least has a structure in which the ¹²C film is grown on the ¹³C film, with the characterizing features as recited in the appending Claim 1.
The reason for overcoming a limitations on physical properties of material by the isotope diamond stacked body of the present invention can be clearly explained with regard to the physical properties of diamonds. Practically, a diamond has a strong chemical inactivity and resistance at room temperature. Hardness, heat conductivity, and sonic propagation speed in a crystal of the diamond is the highest and the friction coefficient is the lowest among the existing materials. In addition, the tuning range of a band-gap caused by the isotope effect of a diamond shows a relatively large value of 19 meV. Further, the thermal expansion coefficient of the diamond is comparative to the thermal expansion coefficient of a silica glass which is the lowest among the existing materials. The diamond has high dielectric break-down strength and low permittivity. An extreme difference in carrier mobility between electrons and holes as shown in a GaAs is not observed and high speed symmetrical mobility is observed in a diamond. Figure of merit (performance index) combining values of those physical properties is proposed in an application of a device. For example, the Johonson index is used as a figure of merit of a high power high frequency device. The Johonson index of a diamond is 46656 times that of Si, and 49 times that of GaN. Further, diamond also shows high performance in other semiconductor properties. For example, diamond has low permittivity and high heat conductivity. These properties are directly required for increasing an integration density and operation speed of a device. The Keyes index representing the performance of a high-density high-speed device is relatively higher when diamond is used compared to other semiconductor materials. In the Keyes index, diamond shows a possibility of device performance of 33 times that of Si, 7 times that of 4H-SiC, and 19 times that of GaN. That is diamond has a performance remarkably surpassing the performance of other semiconductor materials.

On the other hand, an important concept of a technology for obtaining the super-lattice effect is a way to prepare a semiconductor having a tuned band-gap. In general, achievement of super-lattice structure is tried by forming layered junction of semiconductors of hetero-species having an optimized thickness in the range of mono-atomic thickness to several tens of nm. Different from such junction, the present invention intends to realize a junction of semiconductors of homo-species using isotope diamonds. Technology for synthesizing ¹²C diamond and ¹³C diamond is inevitable to realize such a junction.

The substrate used in the present invention is not limited to a specific material. Diamond substrate may be preferably used. Specifically, a diamond substrate having a surface of (001), (110), (111), or (113) crystallographic plane is preferably used. The diamond substrate may be made of a single crystalline diamond or of a polycrystalline diamond. To synthesize a defect-less high quality diamond film, it is preferable to use a single crystalline diamond plate synthesized under high-pressure and high-temperature conditions as the substrate, and homo-epitaxially grow the diamond films.

Synthesis of a diamond stacked body according to the present invention may be performed by any of chemical vapor deposition methods including micro-wave plasma CVD method (e.g., of 915MHz or 2.45MHz in frequency), hot-filament method, electron assisted method, Plasma Torche method, Electron Cyclotron Resonance method (ECR), DC discharge plasma method, RF (radio-frequency) plasma method, RF induction thermal Plasma method, DC plasma Jet method, combustion flame method or the like. Especially, where the diamond film is synthesized using a diamond growth by micro-wave plasma CVD, it is possible to control the growth of a defect-less crystal having a flatness of atomic scale which is an inevitable feature of a super-lattice structure (see "Homoepitaxial diamond film with an atomically flat surface over a large area" in Diamond and Related Materials 8 (1999), 1272-1276).

In the following, a method of producing a diamond stacked body of the present invention using micro-wave plasma CVD method is explained.
A micro-wave plasma CVD apparatus having a reaction chamber made of stainless steel is used in the production of diamond stacked bodies according to the present invention. The apparatus is mainly constituted of a micro-wave power supply, a reaction chamber, a raw material gas supplying unit, and an evacuation unit.

A raw material gas for producing the isotope diamond stacked body of the present invention may be selected from any gas containing carbon, for example, methane gas, carbon dioxide, carbon monoxide or the like. In general, methane gas (CH₄) is used as the raw material. By modifying the CH₄ to ¹²CH₄ gas and ¹³CH₄ gas each having isotope purified carbon (C), it is possible to realize an isotope-purified isotope diamond film. Commercially available high purity hydrogen gas and isotope-purified high purity methane gas are used as raw materials. Hydrogen gas having a purity level of 9N is used so as to suppress influence of residual carbon in the hydrogen gas that constitutes the main part of the raw materials. Residual impurities such as carbon monoxide (CO), carbon dioxide (CO₂), hydrocarbon (e.g., CH₄) or the like have been removed from the hydrogen gas of this level.

After removing a surface contaminant from a substrate and setting the substrate in the reaction chamber, the substrate is heated and maintained at a predetermined temperature while flowing the purified hydrogen gas in order to remove the residual carbonaceous (carbon-containing) gas in the reaction chamber. After that, by introducing the raw material gas, a ¹²C diamond film and a ¹³C diamond film are stacked alternately. When the isotope gas is changed to form the stacked structure, residual carbonaceous gas in the reaction chamber is removed by the above-described flow of highly purified hydrogen gas and heating of the substrate without removing the substrate from the reaction chamber.

The thickness of the film is controlled by controlling the duration (time) of the synthesis in accordance with the preliminary monitored growth rate.
The tuning of the band-gap in the isotope diamond is performed by controlling a mixing ratio of ¹²CH₄ gas and ¹³CH₄ gas as raw materials of the diamond utilizing an isotope effect determined by isotope ratio in the crystal.

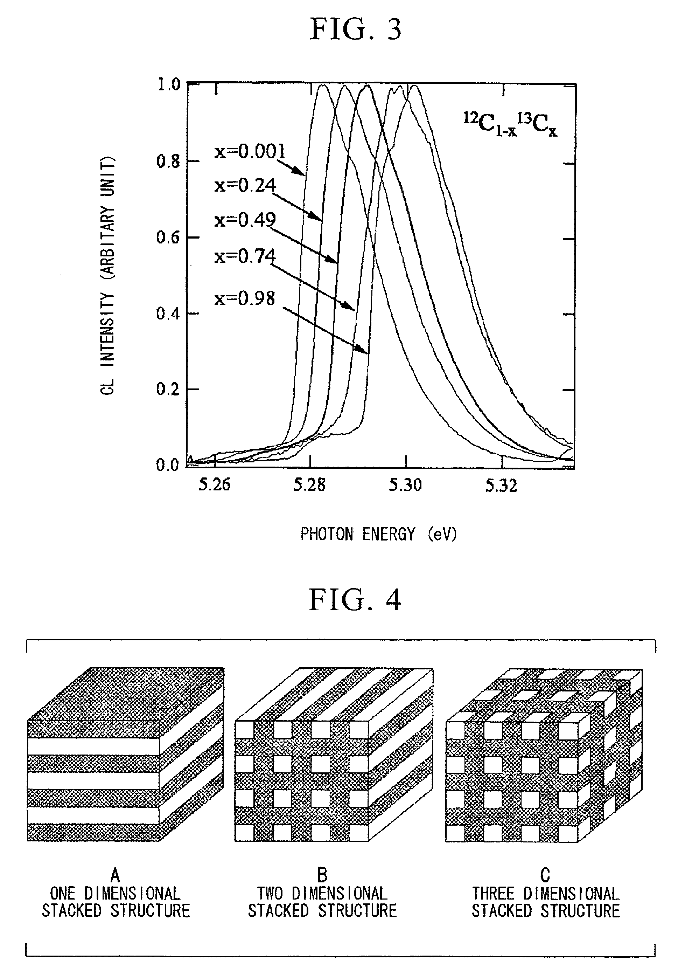

FIG. 3 shows a change of exciton luminescence peak in accordance with the change of ¹³CH₄ gas concentration (x) during growing the diamond. Observation of exciton luminescence peak was performed by a cathode luminescence method. The sample was excited by an electron beam of 13kV in an acceleration voltage and 2 µA in a beam current. The temperature of the sample was 80K. The mixing ratio of the ¹²CH₄ gas and ¹³CH₄ gas was controlled using a mass flow controller. The raw material gasses of the controlled flow rates controlled by the mass flow controllers were mixed by a manifold before being introduced into the synthesis chamber, and were introduced into the synthesis chamber in a desired mixing ratio.
As it is understood from FIG. 3, exciton luminescence peak accompanying the change of band-gap changes reliably in accordance with controlling the desired gas mixing ratio. This result means that the band-gap can be tuned by controlling the compositional ratio of the carbon isotopes.

By the above-explained technology, it is possible to form a multi-layered (plural-layered) structure having a desired barrier height, a desired barrier interval, and a desired number of repeated stacking (layering) with a considerable degree of freedom. In addition, based on the above-described fundamental procedure, a p-type diamond or a n-type diamond can be freely formed by introducing impurities into the environment of diamond film growth.
While the above-description mainly relates to a type I super lattice structure, a two-dimensional or three-dimensional stacked structure of a diamond as shown in FIG. 4 can be realized by a production method utilizing a semiconductor processing. Here, for example, dark portions represent ¹³C diamonds and white portions represent ¹²C diamonds in the figures. For example, there is a method for processing a one-dimensionally stacked structure in a ridge-like or mountain-like form using lithography, etching, or the like. By using such process, it is possible to form a two-dimensional or three-dimensional stacked structure in a desired form.

### Examples

Next, the present invention is explained further in detail based on the Examples. It should be noted that the present invention is not limited to the examples described below.

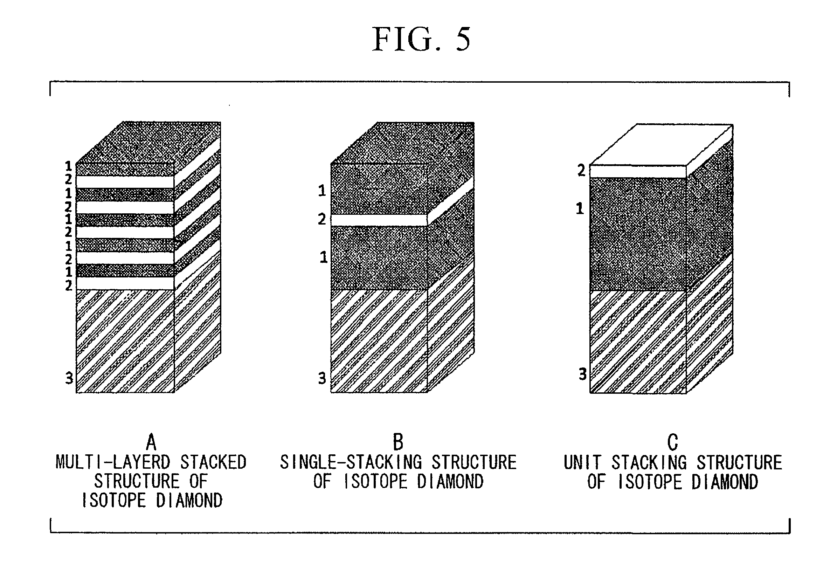

FIGS. 5A, B, C each schematically shows a stacked structure of ¹²C diamond film and ¹³C diamond film produced in Examples 1 to 4. In the figure, 1 denotes ¹³C diamond film, 2 denotes ¹²C diamond film, and 3 denotes a high-pressure high-temperature synthesized diamond used as the substrate.

### Example 1

In the Example, a high-pressure high-temperature synthesized single crystalline diamond plate having a surface of (001) crystallographic plane was used as a substrate. Using an end-lauch type micro-wave plasma CVD apparatus having a reaction chamber made of a stainless steel, stacked (layered) body having a structure shown in FIG. 5A was produced. A magnetron having a maximum power output of 1.5kW, and a frequency of 2.45GHz was used as the micro-wave power supply.
Before setting the diamond plate in the reaction chamber, surface contaminants were removed by performing heat-cleaning using peroxide water, fluoric acid cleaning, ultra-sonic cleaning using an organic solvent, and boiling cleaning using ultra-pure water. Highly pure commercial level hydrogen gas and isotope purified high purity methane gas were used as raw material gasses. Just before mixing the hydrogen gas with the methane gas, the hydrogen gas was purified to the hydrogen gas having a purity level of 9N by removing residual impurities such as carbon monoxide (CO), carbon dioxide gas (CO₂), hydrocarbon (e.g., CH₄) or the like using a hydrogen defecator utilizing a chemical absorption process by a platinum catalyst.

The cleaned diamond plate was set on a stage in the reaction chamber. The interior of the chamber was maintained at a vacuum conditions in the order of 10⁻⁸ Torr. By using a potentiometer, it was confirmed that pressure of residual carbonaceous gas was in the order of 10⁻⁹ Torr or not higher than the detection limit.
Next, before depositing the diamond film, the substrate was maintained at 800°C for at least 5 hours while flowing the hydrogen gas purified by the above-described hydrogen purification so as to remove the residual carbonaceous gas in the reaction chamber.
After that, the above-described gasses were mixed uniformly while controlling the flow rate of each gas by the mass flow controller, and the mixed gas was introduced as a gas shower into the chamber from a shower head placed in an upper part of the reaction chamber. Under the conditions of a substrate temperature of 800°C, a micro-wave power of 750W, a total gas pressure of 25 Torr, a total gas flow rate of 400 SCCM, and a mixing ratio of hydrogen/methane of 0.15%, ¹²C diamond films and ¹³C diamond films were deposited alternately. At that time, mixing ratio of the gas was controlled such that hydrogen constituted 99.85% of the mixed gas, and methane constituted the rest of 0.15%.
When the isotope gas was changed to form the stacked structure, residual carbonaceous gas in the reaction chamber was removed by the flow of highly purified hydrogen gas and heating of the substrate without removing the substrate from the reaction chamber.

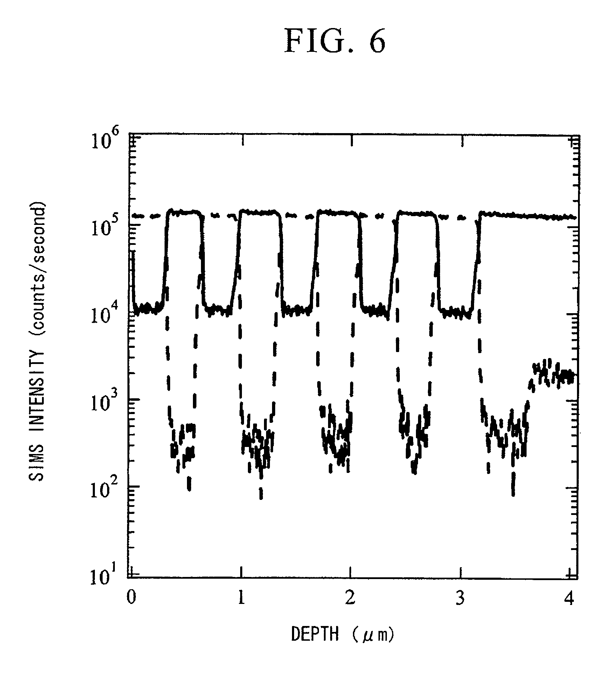

To examine the stacked structure of diamond obtained in Example 1, crystal composition of the thus obtained sample was measured using Secondary Ion Mass Spectroscopy (SIMS). The result is shown in FIG. 6. In the SIMS measurement, O²⁺ ion beam accelerated to 5.5 kV was irradiated to the sample surface. In the figure, solid liner denotes ¹²C diamond films, and the dotted line denotes ¹³C diamond film.
As it can be seen in FIG. 6, a stacked structure of ¹²C diamond films and ¹³C diamond films each having a thickness of 350 nm was realized.

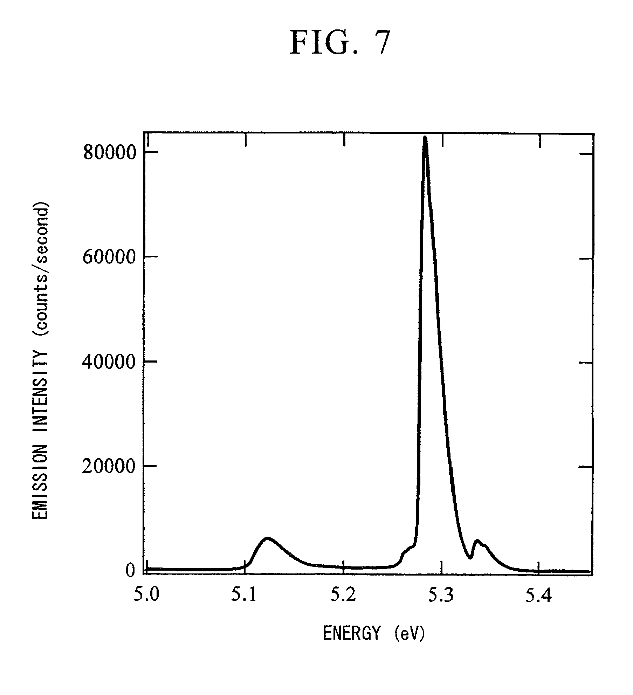

According to the present invention, in the ¹²C diamond film having relatively smaller band-gap compared to the ¹³C diamond film, as shown in FIG. 3, it was possible to form quantum-well state which was capable of confining carriers in the semiconductor layer.
Therefore, the electronic state of a structure of FIG. 5A was examined by evaluation using a cathodeluminescence method. FIG. 7 shows the results. In the observation of luminescence spectrum, an electron beam of 13 kV in acceleration voltage and 2 µA was used. The observation temperature of the luminescence spectrum was 80K. The penetration length (observation depth) of the electron beam was 1.4 µm.
As it can be seen in the schematic figure, clear luminescence from excitons was observed. At that time, although the structure of the crystal was constituted by assembled ¹²C diamond films and ¹³C diamond films as apparently shown in FIG. 6A, as shown in the peak position, the luminescence spectrum shown in FIG. 7 was only observed in the luminescence from the ¹²C diamond film. This result shows that the carrier-recombination region is limited to ¹²C diamond film and ensures a presence of "carrier confinement effect" which is one of characteristic properties of a super-lattice.
By generating carriers in the stacked structure by excitation (using photo-radiation, electron beam, radiant ray, x ray, charged particles, electric field or the like) from the outside, the generated carrier is accumulated in the ¹²C diamond film. Since the carrier is accumulated in the semiconductor layer constituting the well, recombination probability increases compared to the free space. The effective recombination results in increase of luminescence intensity.

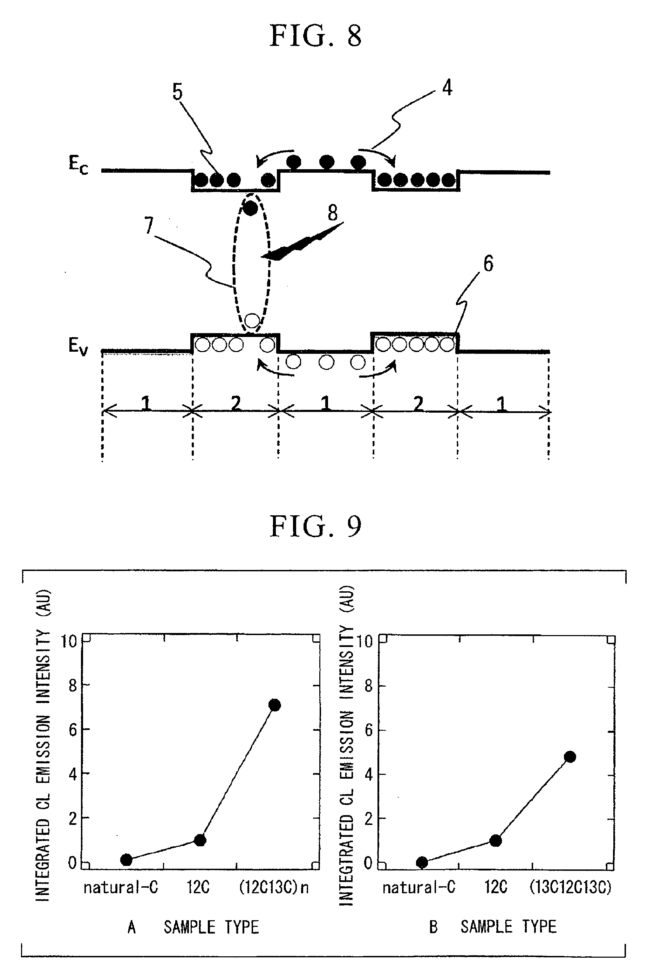

FIG. 8 is a schematic drawing that shows the above-explained phenomena. In the figure, 1 and 2 shows a ¹³C diamond film and a ¹²C diamond film respectively. 4 shows a flow of carriers. 5 and 6 represents an electron and a hole. 7 and 8 denotes an exciton and a recombination luminescence process from the ¹²C diamond film respectively.

FIG. 9A shows plotting of intensities of cathodeluminescence emitted from excitons when the electron beam of the same excitation conditions is radiated to each of the samples. In this figure, "natural-C" denotes a diamond synthesized using CH₄ gas which were not isotope purified. "¹²C" denotes a ¹²C diamond film, and "(¹²C¹³C)n" denotes a sample having a structure shown in FIG. 5A. For comparison, integrated intensity of luminescence from natural-C was set at 1, and relative variations from this sample are shown in the figure. As shown in the figure, compared to the natural-C sample having natural isotope abundance ratio, and ¹²C diamond film sample, luminescence intensity was improved nearly one order in the (¹²C¹³C)n sample having a layered structure shown in FIG. 5A.

### Example 2 (Reference Example, not within the scope of the invention)

An isotope diamond stacked body having a structure shown in FIG. 5B was produced using conditions similar to Example 1 except for a duration of synthesis based on the growth rate calculated from FIG. 6. The thus obtained diamond films respectively had film thicknesses of 875 nm, 350 nm, and 1750 nm from the upper side. While the structure of FIG. 5A obtained in Example 1 is a multi-layered (or quantum well) structure, the structure of Example 2 is a single-stacking (or quantum well) structure.
FIG. 9B shows a result of Example 2. As it can be seen in FIG. 9B, photo-amplification effect can be confirmed in the "(¹³C¹²C¹³C)" structure shown in FIG. 5B as in the structure of FIG. 5A. Since this structure has a simple constitution, it can be used as a test structure for controlling an optimum barrier height and an optimum barrier interval.

### Example 3 Reference Example, not within the scope of the invention.

An isotope diamond stacked body having a structure shown in FIG. 5B was produced in a similar manner as in Example 2, whereas the substrate temperature was set at 900°C, the micro-wave power was 1200W, the total gas pressure was 80 Torr, the total gas flow rate was 100 SCCM, and hydrogen/methane mixing ratio was 1.2%. The thus obtained diamond films respectively had film thicknesses of 875 nm, 350 nm, and 1750 nm from the upper side. Like as the structure of FIG. 5A and FIG. 5B, photo-amplification effect was confirmed.

### Example 4 Reference Example, not within the scope of the invention.

An isotope diamond stacked body having a structure shown in FIG. 5C was produced using conditions similar to Example 1 except for a duration of synthesis based on the growth rate calculated from FIG. 6. The thus obtained diamond films each had film thicknesses of 350 nm, and 3150 nm from the upper side.

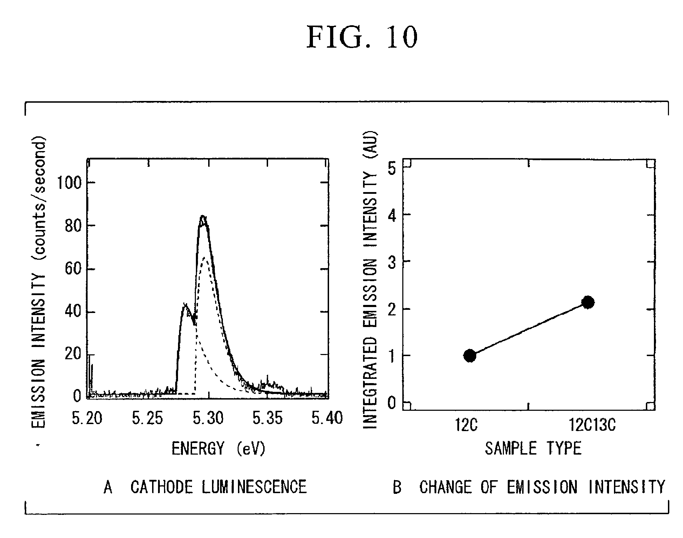

FIG. 10 shows a result of Example 3, and shows change of spectrum in A and change of luminescence in B. As it is understood from FIG. 10A, two peaks were observed in the spectrum. The peak of low energy peak position is attributed to ¹²C diamond film, and the peak of high energy peak position is attributed to the luminescence from the ¹³C diamond film. The result shows that recombination luminescence also occurs also in the ¹³C diamond film, probably caused by diffusion length of carrier generated by the electron beam excitation. However, as shown in FIG. 10, compared to the free space of ¹²C diamond film (sample type ¹²C), the luminescence intensity per unit amount was amplified to 2 fold only by forming the structure of FIG. 5C.

### INDUSTRIAL APPLICABILITY

Isotope purification of semiconductor materials other than carbon still remains a subject of laboratory research, and requires very difficult processes for obtaining the isotope purified materials. On the other hand, carbon isotopes are already used in many fields such as medical care, environmental research, archeological dating and the like. Because of development of measuring techniques and purification techniques, it is easy to obtain carbon isotope materials of specifically high purity. Therefore, the present invention utilizing isotope diamonds constituted of carbon, has overwhelming advantages for industrial applications in the context of a supply of raw materials.
Application of diamond semiconductor to a power device requiring high temperature, high current, and high dielectric strength operation, high speed transistors, high frequency devices, deep ultraviolet ray emitting devices, ultraviolet ray detecting devices, superconductor devices, radiant ray detectors, biosensor, quantum computing devices and the like is currently studied. The present invention provides the principal concept of realizing such next-generation semiconductor materials composed of diamond, and enhances its industrial application.

## Claims

1. A stacked body of isotope diamonds, comprising a ¹³C film composed of carbon isotope ¹³C and a ¹²C film composed of carbon isotope ¹²C grown on a substrate by epitaxial growth, wherein the stacked body at least has a structure in which the ¹²C film is grown on the ¹³C film, **characterized in that** the ¹²C film and the ¹³C film are alternately stacked plural times, and the thickness of the ¹²C film and the thickness of the ¹³C film are the same.

2. A stacked body of isotope diamonds according to claim 1, wherein the thickness of the ¹²C film and the ¹³C film is monoatmic layer thickness to 350 nm or more.

3. A stacked body of isotope diamonds according to claim 1 or 2, wherein the substrate is a diamond substrate.

4. A stacked body of isotope diamonds according to any one of claims 1 to 3, wherein the diamond substrate is made of a single crystalline diamond, and the epitaxial growth is homoepitaxial growth.

5. A method of producing a stacked body of isotope diamonds according to claim 1, including epitaxially growing a ¹³C film composed of carbon isotope ¹³C and a ¹²C film composed of carbon isotope ¹²C on a substrate by CVD method using isotope-refined raw material gases, the method comprising performing removal of a residual gas containing unnecessary carbon from an interior of a reaction chamber by a flow of hydrogen gas having a purity level of 9N and heating of the substrate, wherein the removal of the residual gas is performed before forming the films, and in the time of changing the isotope-refined raw material gas.

## Patentansprüche

1. Gestapelter Isotopen-Diamantkörper, umfassend einen ¹³C-Film, der aus dem Kohlenstoffisotop ¹³C zusammengesetzt ist, und einen ¹²C-Film, der aus dem Kohlenstoffisotop ¹²C zusammengesetzt ist, der auf einem Substrat durch Epitaxialwachstum gezüchtet worden ist, worin der gestapelte Körper wenigstens eine Struktur aufweist, in der der ¹²C-Film auf dem ¹³C-Film gezüchtet ist, **dadurch gekennzeichnet, dass** der ¹²C-Film und der ¹³C-Film mehrfach abwechselnd gestapelt sind und die Dicke des ¹²C-Films und die Dicke des ¹³C-Films gleich sind.

2. Gestapelter Isotopen-Diamantkörper gemäß Anspruch 1, worin die Dicke des ¹²C-Films und des ¹³C-Films monoatomare Schichtdicke bis 350 nm oder mehr beträgt.

3. Gestapelter Isotopen-Diamantkörper gemäß Anspruch 1 oder 2, worin das Substrat ein Diamantsubstrat ist.

4. Gestapelter Isotopen-Diamantkörper gemäß einem der Ansprüche 1 bis 3, worin das Diamantsubstrat aus einem einkristallinen Diamant hergestellt ist und das epitaxiale Züchten homo-epitaxiales Züchten ist.

5. Verfahren zum Herstellten eines gestapelten Isotopen-Diamantkörpers gemäß Anspruch 1, umfassend epitaxiales Züchten eines ¹³C-Films, der aus dem Kohlenstoffisotop ¹³C zusammengesetzt ist, und eines ¹²C-Films, der aus dem Kohlenstoffisotop ¹²C zusammengesetzt ist, auf einem Substrat durch ein CVD-Verfahren unter Verwendung isotopen-raffinierter Rohmaterialgase, wobei das Verfahren das Durchführen durch Entfernung eines Restgases, das unnötigen Kohlenstoff enthält, aus dem Innenraum einer Reaktionskammer durch einen Strom von Wasserstoffgas mit einem Reinheitsgrad von 9N und Erwärmung des Substrats, worin das Entfernen des Restgases vor Bilden des Films und während des Austauschs des isotopen raffinierten Rohmaterialgases durchgeführt wird.

## Revendications

1. Corps empilé de diamants isotopes, comprenant un film de ¹³C composé de l'isotope de carbone ¹³C et un film de ¹²C composé de l'isotope de carbone ¹²C développés sur un substrat par croissance épitaxiale, dans lequel le corps empilé a au moins une structure dans laquelle le film de ¹²C est développé sur le film de ¹³C,
**caractérisé en ce que** le film de ¹²C et le film de ¹³C sont empilés de façon alternée un nombre multiple de fois, et l'épaisseur du film de ¹²C et l'épaisseur du film de ¹³C sont la même.

2. Corps empilé de diamants isotopes selon la revendication 1, dans lequel l'épaisseur du film de ¹²C et du film de ¹³C est une épaisseur de couche monoatomique à 350 nm ou plus.

3. Corps empilé de diamants isotopes selon la revendication 1 ou 2, dans lequel le substrat est un substrat de diamant.

4. Corps empilé de diamants isotopes selon l'une quelconque des revendications 1 à 3, dans lequel le substrat de diamant est constitué d'un diamant monocristallin, et la croissance épitaxiale est une croissance homo-épitaxiale.

5. Procédé de production d'un corps empilé de diamants isotopes selon la revendication 1, incluant la croissance épitaxiale d'un film de ¹³C composé de l'isotope de carbone ¹³C et d'un film de ¹²C composé de l'isotope de carbone ¹²C sur un substrat par un procédé de CVD en utilisant des gaz de matières premières à raffinage isotopique, le procédé comprenant l'exécution d'une élimination d'un gaz résiduel contenant du carbone inutile d'un intérieur d'une chambre de réaction par un flux de gaz hydrogène ayant un niveau de pureté de 9N et le chauffage du substrat, dans lequel l'élimination du gaz résiduel est exécutée avant la formation des films, et au moment d'un changement du gaz de matières premières à raffinage isotopique.
